# EUROPEAN PATENT SPECIFICATION

(11) **EP 3 378 287 B1**
(45) Date of publication and mention of the grant of the patent: **13.03.2024**
(21) Application number: 15797647.3
(22) Date of filing: 18.11.2015
(51) Int. Cl.: H05K 1/02, H01R 12/71, H02K 29/00

(54) **GROUNDING OF PRINTED CIRCUIT BOARD IN A FLUID PUMP**
ERDUNG EINER LEITERPLATTE IN EINER FLÜSSIGKEITSPUMPE
MISE À LA MASSE D'UNE CARTE DE CIRCUIT IMPRIMÉ DANS UNE POMPE HYDRAULIQUE

(43) Date of publication of application: 26.09.2018
(73) Proprietor: Pierburg Pump Technology GmbH, 41460 Neuss (DE)
(72) Inventor: GROSS, Peter, 40699 Erkrath (DE); DÖRRER, Axel, 04357 Leipzig (DE); MARZOG, Ronny, 41464 Neuss (DE); RUSZCZYK, Jakob, 50968 Köln (DE)
(74) Representative: terpatent Patentanwälte und European Patent Attorneys ter Smitten Eberlein -Van Hoof
(86) International application number: PCT/EP2015/076905
(87) International publication number: WO 2017/084702

(56) References cited:
- EP-A2- 2 244 545
- CA-A1- 2 895 591
- DE-A1-102011 004 527
- US-A- 2 752 580
- US-A- 5 497 546
- US-A1- 2014 079 578
- US-A1- 2014 132 122

## Description

The present invention refers to an automotive brushless electric fluid pump, especially to an automotive coolant pump.

The fluid pump comprises a pump unit for pumping the fluid, a printed circuit board for electronically commutating a driving motor driving the pump unit and a massive electrical ground body. The fluid pump further comprises an electric circuit layer comprising an electric ground contact, which is electrically connected to the massive electrical ground body.

CA2895591 A1 and CA2895591 C disclose fluid pump with a grounding bolt inserted in a bore of the motor body.

US 2014/0079578 A1 discloses an automotive electric fluid pump with a printed circuit board.

US 2 752 580 A and US 5 497 546 A disclose bolts and sleeves for connecting printed circuit boards with each other.

The object of the present invention is to provide a brushless electric fluid pump having a simple construction which allows an economical production process.

This object is solved with a brushless electric fluid pump having the features of claim 1.

The fluid pump according to the invention is provided with a longitudinal ground contact element providing a flange portion, which is soldered to the electrical ground contact of the printed circuit board, so as to be electrically and mechanically connected to the electrical ground contact of the printed circuit board. This feature has the effect that the ground contact element can be directly electrically and mechanically connected with the printed circuit board during the manufacturing process of the printed circuit board. Accordingly, the ground contact element is preferably made of an electrically conductive material respectively metals like e.g. aluminum.

The ground contact element further provides a fixing portion, which is engaged in a bore provided in a massive electrical ground body. A bore according to the invention could have any shape and therefore does not necessarily be cylindrical. A fixing portion according to the present invention is a portion, which establishes a permanent mechanical connection with the massive electrical ground body. Accordingly, the printed circuit board can be directly electrically and mechanically connected to the massive electrical ground body by simply pushing the ground contact element into the bore of the massive electrical ground body in an axial direction. Therefore, no screw-process is required for electrically and mechanically connecting the ground contact element to the massive electrical ground body.

Furthermore, as the printed circuit board also is electrically connected to the massive electrical ground body by the ground contact element no further fixation measures for establishing a permanent and reliable electrical contact is required. Thereby, the number of parts of the fluid pump is decreased, some mounting steps are avoided so that manufacturing of the fluid pump is simplified and the fluid pump can be manufactured more economically.

According to a preferred embodiment of the present invention the free end of the ground contact element and the bore have a cylindrical shape so that the ground contact element and the corresponding bore can be manufactured economically. Furthermore, the mounting process is simplified.

According to a further preferred embodiment of the present invention the ground contact element is provided with a head extending through an opening in the printed circuit board. Preferably, the head is a cylindrical body provided at the flange on a side opposite to the free end of the ground contact element. The head extends through the opening to a side of the printed circuit board which is opposite to the side comprising the electric circuit layer. This has the effect that electric ground potential also can be established on a side of the printed circuit board, which does not provide an electric circuit layer. The printed circuit board therefore provides a ground contact on both sides thereof.

Preferably, the head is provided with a plug portion so that a corresponding plug is electrically and mechanically connectable to the head. The plug portion preferably is either provided as a female or as a male plug portion. By providing a plug portion a ground contact connection on a side opposite to the side of the electric circuit layer of the printed circuit board can be easily established. A ground contact plug thereby can be easily connected to the ground contact without further fixation methods like e.g. soldering, welding etc.. The fluid pump therefore can be manufactured more easily and more economically.

According to a further preferred embodiment the flange portion is formed as a cylindrical body. A cylindrical body is easily to manufacture. Furthermore a flange can be easily soldered to the ground contact of the electric circuit layer. Therefore, the fluid pump can be manufactured more easily and more economically.

The flange portion is preferably soldered with the printed circuit board at an edge region of the flange portion.

Preferably, the bore is formed conically so that the radius of the bore decreases with increasing bore depth. The diameter of the bore decreases with penetration depth of the free end of the ground contact element. Thereby, with increasing penetration depth of the free end, the clamping effect between the bore and the longitudinal portion increases. The mechanical connection between the ground contact element and the massive electrical ground body thereby is improved. Furthermore, the electrical resistance between the ground contact element and the massive electrical ground body is minimized.

In a further preferred embodiment the fixing portion of the ground contact element is provided with ripples, which form circumferential rings. Ripples according to the invention are wavelike structures so that the diameter of the fixing portion in an axial direction alternates. The special formation of the fixing portion causes an improved clamping effect.

In an alternative embodiment the fixing portion of the ground contact element is provided with a sawtooth profile. The sawtooth profile according to the invention is provided so as to allow a movement of the ground contact element into the bore but to block a movement of the ground contact element in an opposite direction. The sawtooth profile has the effect that the ground contact element is more effectively engaged in the bore.

In a preferred embodiment of the present invention the bore is provided with a bore fixing structure portion interacting with the corresponding fixing portion of the ground contact element. The advantage of the bore fixing structure portion is that the ground contact element is more effectively engaged in the bore. In a further preferred embodiment the bore fixing portion is provided with ripples interacting with ripples of the fixing portion of the ground contact element. Thereby the ripples of the bore fixing portion and the ripples of the fixing portion of the ground contact element meshes so that an improved fixing effect is achieved.

In a further preferred embodiment of the present invention the massive electrical ground body is a heat sink. This has the effect that no separate heat sink body has to be provided. Thereby, the number of parts is decreased so that the fluid pump is simple and can be manufactured more economically.

Further advantages will become evident by the following detailed description of an embodiment of the invention in combination with the drawings, which show:
Figure 1 shows a longitudinal section of an automotive brushless electric fluid pump according to an embodiment of the present invention,
Figure 2 enlarged section showing a ground connection of the printed circuit board of the fluid pump of Fig. 1, and
Figure 3 ground contact element according to a second embodiment of the present invention.

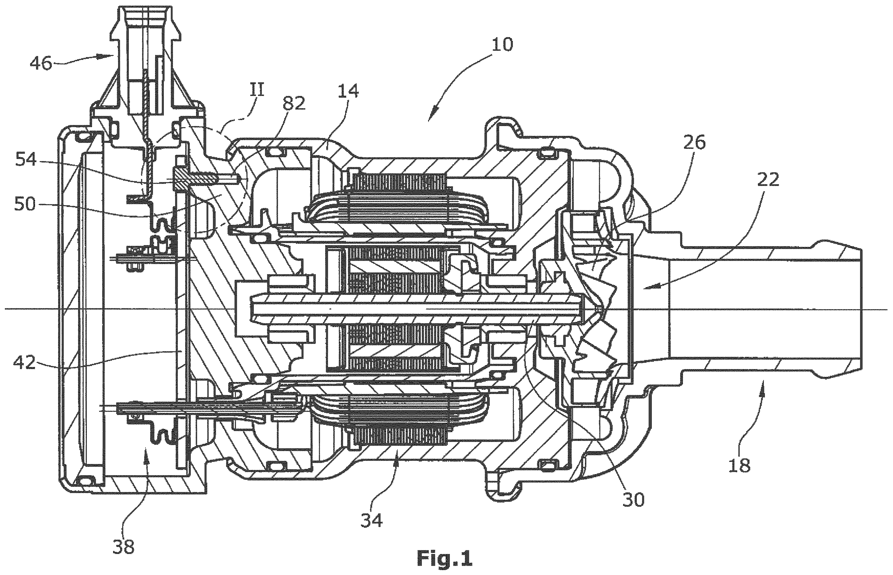

Figure 1 shows an automotive electronically commutated fluid pump 10 according to the invention.

The fluid pump 10 comprises housing 14 with an axial inlet opening 18 and a radial outlet opening (not shown) for the fluid. A pump unit 22 is provided inside the housing 14 between the inlet opening 18 and the outlet opening. The pump unit 22 comprises a radially pumping impeller 26 for pumping the fluid. The impeller 26 of the pump unit 22 is mechanically driven via a shaft 30 by an electronically commutated driving motor 34.

The fluid pump 10 comprises an electronic compartment 38 at a side axially opposite to the axial inlet opening 18. A printed circuit board 42 is provided inside the electronic compartment 38. The printed circuit board 42 is electrically connected to the electronically commutated driving motor 34 for electronically commutating the driving motor 34. A socket 46 is provided at one side of the electronic compartment 38 so that the printed circuit board 42 is electrically connectable to a power source and a control unit. The electronic compartment 38 is defined by a massive electrical ground body 50 to which the printed circuit board 42 is electrically and mechanically connected by a cylindrical ground contact element 54.

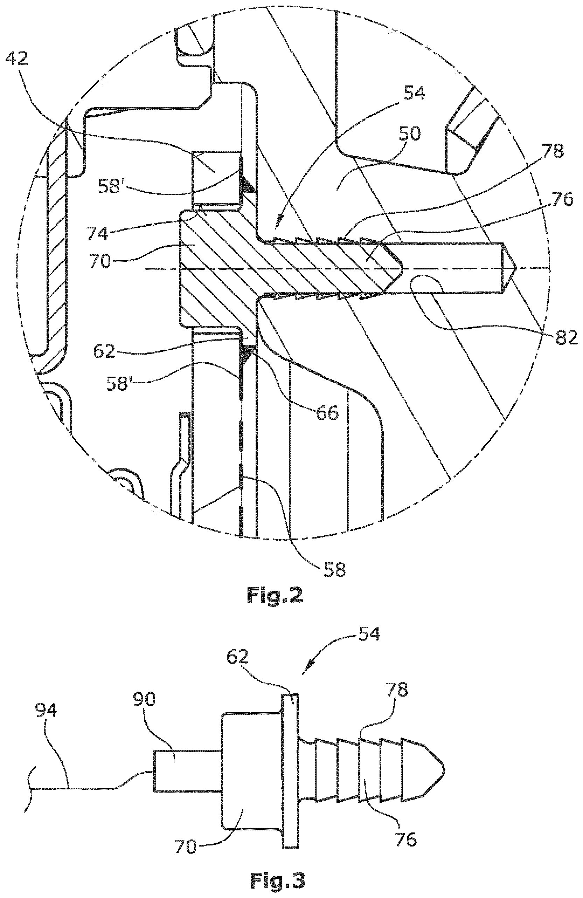

Fig. 2 shows an enlarged section of the cylindrical ground contact element 54, electrically and mechanically connecting the massive electrical ground body 50 with an electric ground contact 58' of an electric circuit layer 58 provided on a side of the printed circuit board 42 facing the massive electrical ground body 50. The cylindrical ground contact element 54 provides a flange portion 62, which is electrically and mechanically connected via a soldered seam 66 to the electrical ground contact 58' of the electric circuit layer 58. The cylindrical ground contact element 54 provides a cylindrical head portion 70 extending from the flange portion 62 through an opening 74 provided in the printed circuit board 42. The cylindrical ground contact element 54 provides a fixing portion 78 at a free end 76 opposite to the head portion having a sawtooth profile. The fixing portion 78 of the cylindrical ground contact element 54 is preferably minimally conical and is inserted into a bore 82 of the massive electrical ground body 50 so as to establish a mechanical and electrical connection between the printed circuit board 42 and the massive electrical ground body 50.

Fig. 3 shows a second embodiment of the cylindrical ground contact element 54 according to the present invention. The head 70 is provided with a plug portion 90 formed on a top portion of the head 70. The plug portion 90 is formed as a tab portion. The plug portion 90 is formed so that a corresponding plug, comprising an electrical wire 94, is electrically connectable to the head 70 of the cylindrical ground contact element 54.

### Reference signs

- 10: fluid pump
- 14: housing
- 18: inlet opening
- 22: pump unit
- 26: radial impeller
- 30: shaft
- 34: electronically commutated driving motor
- 38: electronic compartment
- 42: printed circuit board
- 46: socket
- 50: massive electrical ground body
- 54: ground contact element
- 58: electric circuit layer
- 58': electrical ground contact
- 62: flange portion
- 66: soldered seam
- 70: cylindrical head portion portion
- 74: opening
- 76: free end
- 78: fixing portion
- 82: bore
- 90: plug
- 94: electrical wire

## Claims

1. An automotive brushless electric fluid pump (10) wherein the fluid pump (10) comprises:
- a pump unit (22) for pumping the fluid,
- a printed circuit board (42) for electronically commutating a driving motor (34) driving the pump unit (22),
- a massive electrical ground body (50),
- an electric circuit layer (58) comprising an electric ground contact (58'), which electric circuit layer (58) is provided on a side of the printed circuit board (42) facing the massive electrical ground body (50),
- a longitudinal ground contact element (54), providing a flange portion (62), which is soldered to the electrical ground contact (58') of the printed circuit board (42), so as to be electrically and mechanically connected to the electrical ground contact (58') of the printed circuit board (42),
- a bore (82) provided in the massive electrical ground body (50) for receiving a free end (76) of the ground contact element (54),
wherein the ground contact element (54) is provided with a fixing portion (78), which is fixed in the bore (82), so as to mechanically and electrically connecting the ground contact element (54) with the massive electrical ground body (50).

2. The automotive brushless electric fluid pump (10) according to claim 1, **characterized in that** the free end (76) of the ground contact element (54) and the bore (82) have a cylindrical shape.

3. The automotive brushless electric fluid pump (10) according to claim 1 or 2, **characterized in that** the ground contact element (54) is provided with a head (70) extending through an opening (74) in the printed circuit board (42).

4. The automotive brushless electric fluid pump (10) according to claim 3, **characterized in that** the head (70) is provided with a plug portion (90) so that a corresponding plug is electrically connectable to the head (70).

5. The automotive brushless electric fluid pump (10) according to one of the preceding claims, **characterized in that** the flange portion (62) is formed as a cylindrical body.

6. The automotive brushless electric fluid pump (10) according to one of the preceding claims, **characterized in that** the flange portion (62) is soldered with the printed circuit board (42) at an edge portion of the flange portion (62).

7. The automotive brushless electric fluid pump (10) according to one of the preceding claims, **characterized in that** the bore (82) is formed conically so that a diameter of the bore (82) decreases with increasing distance to the printed circuit board (42).

8. The automotive brushless electric fluid pump (10) according to one of the preceding claims, **characterized in that** the fixing portion (78) of the ground contact element (54) is provided with ripples.

9. The automotive brushless electric fluid pump (10) according to claims 1 to 7, **characterized in that** the fixing portion (78) of the ground contact element (54) is provided with a sawtooth profile.

10. The automotive brushless electric fluid pump (10) according to one of the preceding claims, **characterized in that** the bore (82) is provided with a bore fixing structure portion interacting with the fixing portion (78) of the ground contact element (54).

11. The automotive brushless electric fluid pump (10) according to one of the preceding claims, **characterized in that** the massive electrical ground body (50) is a heat sink.

## Patentansprüche

1. Eine elektrische Kraftfahrzeug-Fluidpumpe (10), wobei die Fluidpumpe (10) aufweist:
- eine Pumpeinheit (22) zum Pumpen des Fluids,
- eine gedruckte Schaltungsplatine (42) zur elektronischen Kommutierung eines Antriebsmotors (34), der die Pumpeinheit (22) antreibt,
- einen massiven elektrischen Massekörper (50),
- eine elektrische Schaltkreisschicht (58), die einen elektrischen Massekontakt (58') aufweist, wobei die elektrische Schaltkreisschicht (58) auf einer Seite der gedruckten Schaltungsplatine (42) vorgesehen ist, die dem massiven elektrischen Massekörper (50) gegenüberliegt,
- ein längliches Massekontaktelement (54), das einen Flanschabschnitt (62) aufweist, der mit dem elektrischen Massekontakt (58') der gedruckten Schaltungsplatine (42) verlötet ist, um elektrisch und mechanisch mit dem elektrischen Massekontakt (58') der gedruckten Schaltungsplatine (42) verbunden zu sein,
- eine Bohrung (82), die in dem massiven elektrischen Massekörper (50) zum Aufnehmnen eines freien Endes (76) des Massekontaktelements (54) vorhanden ist,
wobei das Massekontaktelement (54) einen Befestigungsabschnitt (78) aufweist, der in der Bohrung (82) befestigt ist, um das Massekontaktelement (54) mit dem massiven elektrischen Massekörper (50) mechanisch und elektrisch zu verbinden.

2. Die elektrische Kraftfahrzeug-Fluidpumpe (10) nach Anspruch 1, **dadurch gekennzeichnet, dass** das freie Ende (76) des Massekontaktelements (54) und die Bohrung (82) eine zylindrische Form aufweisen.

3. Die elektrische Kraftfahrzeug-Fluidpumpe (10) nach Anspruch 1 oder 2, **dadurch gekennzeichnet, dass** das Massekontaktelement (54) mit einem Kopf (70) versehen ist, der sich durch eine Öffnung (74) in der gedruckten Schaltungsplatine (42) erstreckt.

4. Die elektrische Kraftfahrzeug-Fluidpumpe (10) nach Anspruch 3, **dadurch gekennzeichnet, dass** der Kopf (70) einen Steckerabschnitt (90) aufweist, so dass ein entsprechender Stecker elektrisch mit dem Kopf (70) verbindbar ist.

5. Die elektrische Kraftfahrzeug-Fluidpumpe (10) nach einem der vorangehenden Ansprüche, **dadurch gekennzeichnet, dass** der Flanschabschnitt (62) als ein zylindrischer Körper ausgebildet ist.

6. Die elektrische Kraftfahrzeug-Fluidpumpe (10) nach einem der vorangehenden Ansprüche, **dadurch gekennzeichnet, dass** der Flanschabschnitt (62) mit der gedruckten Schaltungsplatine (42) an einem Randabschnitt des Flanschabschnitts (62) verlötet ist.

7. Die elektrische Kraftfahrzeug-Fluidpumpe (10) nach einem der vorangehenden Ansprüche, **dadurch gekennzeichnet, dass** die Bohrung (82) konisch ausgebildet ist, so dass ein Durchmesser der Bohrung (82) mit zunehmendem Abstand zu der gedruckten Schaltungsplatine (42) abnimmt.

8. Die elektrische Kraftfahrzeug-Fluidpumpe (10) nach einem der vorangehenden Ansprüche, **dadurch gekennzeichnet, dass** der Befestigungsabschnitt (78) des Massekontaktelements (54) mit Rillen versehen ist.

9. Die elektrische Kraftfahrzeug-Fluidpumpe (10) nach einem der Ansprüche 1 bis 7, **dadurch gekennzeichnet, dass** der Befestigungsabschnitt (78) des Massekontaktelements (54) ein Sägezahnprofil aufweist.

10. Die elektrische Kraftfahrzeug-Fluidpumpe (10) nach einem der vorangehenden Ansprüche, **dadurch gekennzeichnet, dass** die Bohrung (82) einen Bohrungsbefestigungsstrukturabschnitt aufweist, der mit dem Befestigungsabschnitt (78) des Massekontaktelements (54) zusammenwirkt.

11. Die elektrische Kraftfahrzeug-Fluidpumpe (10) nach einem der vorangehenden Ansprüche, **dadurch gekennzeichnet, dass** der elektrische Massekörper (50) eine Wärmesenke ist.

## Revendications

1. Une pompe à fluide électrique sans balais pour automobile (10), dans laquelle la pompe à fluide (10) comprend :
- une unité de pompage (22) pour pomper le fluide,
- une carte de circuit imprimé (42) pour la commutation électronique d'un moteur d'entraînement (34) entraînant l'unité de pompage (22),
- un corps de masse électrique solide (50),
- une couche de circuit électrique (58) comprenant un contact de masse électrique (58'), laquelle couche de circuit électrique (58) est fournie sur un côté de la carte de circuit imprimé (42) faisant face au corps de masse électrique solide (50),
- un élément de contact de masse longitudinal (54), fournissant une portion de flasque (62), qui est soudée au contact de masse électrique (58') de la carte de circuit imprimé (42), de manière à être connectée électriquement et mécaniquement au contact de masse électrique (58') de la carte de circuit imprimé (42),
- un alésage (82) fourni dans le corps de masse électrique solide (50) pour recevoir une extrémité libre (76) de l'élément de contact de masse (54), dans lequel l'élément de contact de masse (54) est fourni avec une partie de fixation (78), qui est fixée dans l'alésage (82), de manière à connecter mécaniquement et électriquement l'élément de contact de masse (54) avec le corps de masse électrique solide (50).

2. La pompe à fluide électrique automobile sans balais (10) selon la revendication 1, **caractérisée en ce que** l'extrémité libre (76) de l'élément de contact de masse (54) et l'alésage (82) ont une forme cylindrique.

3. La pompe à fluide électrique automobile sans balais (10) selon la revendication 1 ou 2, **caractérisée en ce que** l'élément de contact de masse (54) est pourvu d'une tête (70) s'étendant à travers une ouverture (74) de la carte de circuit imprimé (42).

4. La pompe à fluide électrique automobile sans balais (10) selon la revendication 3, **caractérisée en ce que** la tête (70) est fournie avec une partie de prise (90) de sorte qu'une prise correspondante est connectable électriquement à la tête (70).

5. La pompe à fluide électrique automobile sans balais (10) selon l'une des revendications précédentes, **caractérisée en ce que** la portion de flasque (62) est formée d'un corps cylindrique.

6. La pompe à fluide électrique automobile sans balais (10) selon l'une des revendications précédentes, **caractérisée en ce que** la portion de flasque (62) est soudée avec la carte de circuit imprimé (42) au niveau d'une portion de bord de la portion de flasque (62).

7. La pompe fluide électrique automobile sans balais (10) selon l'une des revendications précédentes, **caractérisée en ce que** l'alésage (82) est formé de manière conique de sorte qu'un diamètre de l'alésage (82) diminue avec l'augmentation de la distance à la carte de circuit imprimé (42).

8. La pompe à fluide électrique automobile sans balais (10) selon l'une des revendications précédentes, **caractérisée en ce que** la partie de fixation (78) de l'élément de contact de masse (54) est pourvue d'ondulations.

9. La pompe à fluide électrique automobile sans balais (10) selon l'une des revendications 1 à 7, **caractérisée en ce que** la partie de fixation (78) de l'élément de contact de masse (54) est pourvue d'un profil en dents de scie.

10. La pompe à fluide électrique automobile sans balais (10) selon l'une des revendications précédentes, **caractérisée en ce que** l'alésage (82) est fourni avec une portion de structure de fixation de l'alésage interagissant avec la partie de fixation (78) de l'élément de contact de masse (54).

11. La pompe à fluide électrique pour automobile sans balais (10) selon l'une des revendications précédentes, **caractérisée en ce que** le corps de masse électrique solide (50) est un dissipateur thermique.
